# EUROPÄISCHE PATENTANMELDUNG

(11) **EP 0 745 862 A2**
(43) Veröffentlichungstag der Anmeldung: **04.12.1996**
(21) Anmeldenummer: 96108516.4
(22) Anmeldetag: 29.05.1996
(51) Int. Cl.: G01R 31/12

(54) **Verfahren und Vorrichtung zum Bestimmen von Isolationseigenschaften von Prüfobjekten**

(30) Priorität: 30.05.1995 DE 19519746
(71) Anmelder: DÄTWYLER AG KABEL + SYSTEME, CH-6460 Altdorf (CH)
(72) Erfinder: Onodi, Tamas, Dr., 6460 Altdorf (CH)
(74) Vertreter: Turi, Michael, Dipl.-Phys.

(57) **Zusammenfassung**

Die Erfindung betrifft ein Verfahren zum Bestimmen von Isolationseigenschaften von Prüfobjekten, insbesondere eines Kabels oder Kabelsystems, unter Wechselgrößenbeaufschlagung, insbesondere im Mittelspannungs- oder Hochspannungsbereich, unter Verwendung einer Schaltung, die ein Prüfobjekt als Kapazität oder Teil einer Kapazität sowie eine Induktivität umfaßt und einen Schwingkreis bildet, mit den Schritten: a) Energieeinspeisen in den Schwingkreis mit Hilfe einer Energieeinspeisevorrichtung, b) Abkoppeln und/oder Ausschalten der Energieeinspeisevorrichtung, so daß der Schwingkreis mit einer im wesentlichen sinusförmigen Schwingung auf der Resonanzfrequenz frei schwingt, und c) Messen von Beiträgen zur Schwingung, welche Abweichungen von der Sinusform bedingen und Information über Isolationseigenschaften tragen, während abgekoppelter bzw. ausgeschalteter Energieeinspeisevorrichtung. Außerdem betrifft die Erfindung eine Vorrichtung zum Durchführen des Verfahrens.

## Beschreibung

Die Erfindung betrifft ein Verfahren und eine Vorrichtung zum Bestimmen von Isolationseigenschaften von Prüfobjekten, wobei insbesondere die Isolationseigenschaften von Kabeln oder Kabelsystemen im Mittelspannungs- oder Hochspannungsbereich untersucht werden sollen.

In Energieübertragungssytemen spielen isolierte Kabel und aus solchen Kabeln und ggf. weiteren Teilen, wie Garnituren aufgebaute Kabelsysteme eine wesentliche Rolle. Eine Störung eines solchen Kabels bzw. Kabelsystems kann durch den Energieausfall z.B. im industriellen Bereich, im Verkehr, bei Heiz- und Kühlsystemen, in Haushalten, öffentlicher Beleuchtung usw. weitaus größere Kosten als die Reparatur des eigentlichen Schadensfalles verursachen. Dementsprechend werden hohe Anforderungen an die Betriebssicherheit solcher Kabel oder Kabelsysteme gestellt.

Um diesen Anforderungen gerecht zu werden, werden bei der Produktion der Kabel und der zu ihrer Verbindung dienenden Garnituren laufend verschiedene Tests durchgeführt. Hierbei handelt es sich u.a. um sog. Spannungsprüfungen, bei denen die Prüfobjekte mit einer über ihrer für den späteren Betrieb vorgesehenen Spannung beaufschlagt werden und dabei auf Durchschlagsfestigkeit getestet werden. Bisweilen führt man in der Produktion auch empfindlichere Isolationsprüfungen, wie etwa - unten noch näher erläuterte - Teilentladungsmessungen durch. Die dabei zu messenden Signale sind relativ zur Testspannung sehr klein, so daß solche Messungen extrem empfindlich gegenüber Störsignalen sind und daher i.a. ein hoher Aufwand mit Abschirmungen und besonders störungsarmen Prüfspannungsversorgungen getrieben werden muß. Derartige Messungen kann man daher i.a. nur in der Produktionsstätte oder im Labor durchführen.

Mit vor der Ablieferung der Kabel und Garnituren durchgeführten Prüfungen können jedoch nicht alle möglichen Fehler ausgeschlossen werden. Denn problematisch ist einerseits der Transport und die Verlegung der Kabel, denn dabei können unbemerkt Beschädigungen entstehen. Andererseits können auch Fehler bei der Installation, also der Errichtung eines Kabelsystems durch die Verbindung von Kabeln untereinander und mit elektrischen Betriebseinrichtungen hervorgerufen werden. Deshalb werden solche Kabel oder Kabelsysteme auch vor der Inbetriebnahme vor Ort auf ihre wichtigste Eigenschaft geprüft. Dies geschieht wiederum durch Beaufschlagen mit Spannung und Überprüfen auf Durchschlagsfestigkeit. Auf diese Weise kann das Vorliegen geforderter Mindest-Sicherheitsreserven der elektrischen Festigkeit nachgewiesen werden.

Bei solchen Vor-Ort-Prüfungen der elektrischen Festigkeit mittels Spannungsprüfung besteht das Problem, daß einerseits relativ große Prüfleistungen benötigt werden, andererseits aber die hierzu erforderlichen Versorgungsanlagen transportabel sein müssen.

Relativ wenig aufwendig ist die Erzeugung geeigneter hoher Gleichspannungen. Während die Spannungsprüfung mit Gleichspannung bei ölpapierisolierten Kabeln eine aussagekräftige Prüfart ist, können jedoch bei kunststoffisolierten Kabeln und bei Garnituren Probleme auftreten. Und zwar können durch die hohen Isolationswiderstände im Kabel erhebliche Raumladungen entstehen, wodurch das elektrische Feld verzerrt wird und vom dem im üblichen Betrieb vorliegenden Feld stark abweicht. Für kapazitive Feldsteuerung ausgelegte Garnituren funktionieren nicht richtig. Die Methode ist auch nicht sehr aussagekräftig, da selbst starke Beschädigungen an polymerisolierten Kabeln durch diese Prüfung nicht unbedingt erfaßt werden. Die o.g. teilweise unkontrollierten Überlastungen können zu weiteren Beschädigungen führen.

Ebenfalls relativ wenig aufwendig ist die Vor-Ort-Erzeugung geeigneter 0,1-Hz-Wechselspannung als Kompromißlösung zwischen Wechselspannungs- und Gleichspannungsprüfungen. Infolge der niedrigen Frequenz können kapazitive Ladeströme klein gehalten werden, so daß der Leistungsbedarf in einem vertretbaren Rahmen bleibt und die Versorgungsanlage leicht und transportfähig bleibt. Es ist jedoch nachteilig, daß die physikalischen Vorgänge im Dielektrikum - fast wie bei Gleichspannung - sehr stark von denjenigen bei Betriebfrequenz - in der Regel ca. 50 oder 60 Hz - abweichen.

Eine derartige Anlage zur Prüfung der Durchschlagfestigkeit verlegter Kunststoffkabel mit Hilfe einer alternierenden Prüfspannung mit geringer Wechselfrequenz (0,1 bis 10 Hz) ist aus DE 37 00 647 A1 bekannt. Diese Anlage arbeitet mit einer Gleichspannungsquelle. Die von ihr gelieferte Gleichspannung repräsentiert eine der Polaritäten (z.B. die positive) der alternierenden Prüfspannung. Zu Zeiten positiver Prüfspannungspolarität ist das Kabel direkt mit der Gleichspannungsquelle verbunden. Um mit Hilfe der Gleichspannungsquelle auch die andere (negative) Polarität der Prüfspannung erzeugen zu können, ist die durch das zu prüfende Kabel gebildete Kapazität mit einer Induktivität zu einem Schwingkreis geschaltet. Der Schwingkreis ist zunächst durch einen Schalter aufgetrennt. Nach Abtrennen der Kapazität von der Gleichspannungsquelle und Schließen des Schwingkreisschalters entlädt sich die Kapazität über die Induktivität und lädt sich in Folge eines Überschwingens auf eine Spannung mit entgegengesetzter (negativer) Polarität auf. Diese stellt die Prüfspannung der anderen Polarität dar. Ein Weiterschwingen nach Erreichen der maximalen negativen Polarität wird verhindert, so daß das Kabel über längere Zeit mit der Prüfspannung negativer Polarität beaufschlagt wird. Erst nach Ablauf dieser längeren Zeit kann sich dieser Entladevorgang in umgekehrter Richtung wiederholen und das Kabel wieder positiv aufladen, um anschließend wieder mit der Gleichspannungsquelle verbunden zu werden und über längere Zeit auf der positiven Prüfspannung zu verbleiben. Dieser Zyklus wiederholt sich mehrmals.

Ferner sind Prüfungen mit schwingenden Spannungsimpulsen bekannt, die die Anlage bzw. das Kabelsystem wiederholt unter eine schnell abklingende, mit ca. 1-10 kHz oszillierende Spannungswelle setzen. Sowohl wegen der hohen Frequenz als auch der kurzen Beanspruchungszeiten ist auch hier die Fehleraufdeckungsquote begrenzt.

Daher hat sich die Spannungsprüfung bei betriebsnahen Frequenzen (z.B. ca. Betriebsfrequenz +/- 0 bis 30 Hz) als am aussagekräftigsten erwiesen. Als Vor-Ort-Prüfung ergibt sich jedoch hier eine besondere Schwierigkeit: Der kapazitive Ladestrom erfordert wegen der großen Kabelkapazitäten einen hohen Leistungsbedarf, wodurch das Gewicht eines die Prüfleistung erbringenden Prüftransformators entsprechend hoch ausfällt, so daß dieser nur noch unter Schwierigkeiten transportabel ist.

Die guten dielektrischen Eigenschaften und insbesondere die geringen Verluste moderner kunststoffisolierter Kabel ermöglichen nun aber die Zusammenstellung von Schwingkreisen mit betriebsnaher Resonanzfrequenz, in denen das zu prüfende Kabel bzw. Kabelsystem die Kapazität und eine transportable Drossel die Induktivität bildet. Die zur laufenden Speisung des Schwingkreises benötigte Leistung ist kleiner als beim o.g. Fall nicht resonanter Beaufschlagung bei betriebsnaher Frequenz. Die Speisung kann einerseits mit vorgegebener Frequenz (insbesondere Netzfrequenz und damit auch der Betriebsfrequenz) erfolgen; dann muß allerdings die Induktivität - was relativ aufwendig ist - verstellbar ausgeführt sein, um die Resonanzfrequenz genau auf die Speisefrequenz abstimmen zu können. Andererseits kann man - was weniger aufwendig ist - aus einem vorgegebenen Satz fester Drosseln eine auswählen, aus der eine betriebsnahe Resonanzfrequenz resultiert, und die Speisung des Schwingkreises von einem in der Frequenz verstellbaren Speisemittel (z.B. einem netzgespeisten Umrichter) erfolgen lassen, das man auf die Resonanzfrequenz einstellt.

Obwohl diese bekannten Spannungs-Prüfmethoden zur Vor-Ort-Prüfung grundsätzlich gut geeignet sind, haben sie auch Nachteile.

Ein Nachteil ist, daß sie auch fehlerfreie Prüfobjekte schädigen können. Bei neuen Prüfobjekten fällt dies kaum ins Gewicht, da diese eine kurze elektrische Überlastung i.a. ohne bleibende Veränderungen und Lebensdauerverkürzung überstehen.

Anders bei bereits gealterten Prüfobjekten, die auch oftmals auf diese Weise geprüft werden müssen. Vorweg sei bemerkt, daß auch bestehende Anlagen bzw. Kabelsysteme wiederholt daraufhin kontrolliert werden müssen, ob die geforderten Mindestsicherheitsreserven der elektrischen Spannungsfestigkeit noch vorliegen. Ferner müssen nach einer Reparatur oder einem Umbau bzw. einer Erweiterung einer bestehenden Anlage bzw. eines Kabelsystems vor der Inbetriebnahme die Sicherheitsreserven kontrolliert werden. Bei älteren Kabeln kann sich nun das Anlegen einer Überspannung schädigend und lebensdauerverkürzend auswirken, selbst wenn die Anlage bzw. das Kabelsystem der Prüfbelastung ohne Durchschlag standhält. Die Spannungsprüfung selbst kann also teilzerstörerisch sein.

Abgesehen von dieser schädigenden Wirkung bei bereits gealterten Prüfobjekten ist eine solche Überspannungsprüfung nur von beschränkter Aussagekraft, da man mit ihr bestimmte Verlegungs-, Installations- und Alterungsfehler, die sich momentan noch nicht in einem Durchschlag zeigen, nicht erkennen kann. Ihre "Frühindikator"-Wirkung ist also begrenzt. Dies ist nachteilig, da zur Vermeidung unerwarteter Schadensfälle mit hohen Folgekosten der Wunsch besteht, frühzeitig vorbeugende Maßnahmen, z.B. vorzeitige Teilauswechselungen, treffen zu können.

Der Erfindung liegt das technische Problem zugrunde, ein Verfahren zum Bestimmen von Isolationseigenschaften von Prüfobjekten, insbesondere von Kabeln oder Kabelsystemen, insbesondere im Hochspannungsbereich bereitzustellen, mit dem diese Nachteile überwunden werden können. Dazu gehört auch die Bereitstellung einer entsprechenden Vorrichtung.

Dieses Problem wird erfindungsgemäß durch ein Verfahren zum Bestimmen von Isolationseigenschaften von Prüfobjekten, insbesondere eines Kabels oder Kabelsystems unter Wechselgrößenbeaufschlagung, insbesondere im Mittelspannungs- und Hochspannungsbereich, gelöst, unter Verwendung einer Schaltung, die das Prüfobjekt als Kapazität oder Teil einer Kapazität sowie eine Induktivität umfaßt und einen Schwingkreis bildet, mit folgenden Schritten:
a) Energieeinspeisen in den Schwingkreis mit Hilfe einer Energieeinspeisevorrichtung,
b) Abkoppeln und/oder Ausschalten der Energieeinspeisevorrichtung, so daß der Schwingkreis mit einer im wesentlichen sinusförmigen Schwingung auf der Resonanzfrequenz frei schwingt und
c) Messen von Beiträgen zur Schwingung, welche Abweichungen von der Sinusform bedingen und Information über Isolationseigenschaften tragen, während abgekoppelter bzw. ausgeschalteter Energieeinspeisevorrichtung (Anspruch 1).

Im Schritt c) wird im allgemeinen eine elektrische Größe (oder mehrere elektrische Größen) gemessen, wie der durch das Prüfobjekt fließende Strom (der i. a. gleich dem im Schwingkreis fließenden Strom ist) oder die am Prüfobjekt abfallende Spannung.

Sobald der Schwingkreis frei schwingt, sterben - unter der Annahme, daß sich alle Elemente des Schwingkreises linear verhalten - nach kürzester Zeit alle Frequenzanteile außerhalb der Resonanzfrequenzüberhöhung des Schwingkreises aus, und es verbleibt - abgesehen von der Dämpfung des Schwingkreises - eine rein sinusförmige Schwingung im Schwingkreis. Auf diese Weise werden Störungen aus dem Netz oder sonstige Störungen, die etwa mit dem Energieeinspeisen zusammenhängen (z.B. von einem Frequenzumrichter herrührende Störsignale), wirksam aus dem Schwingkreis beseitigt. Aufgrund der i.a. sehr verlustarmen Kabelisolationen und der Möglichkeit, auch die verwendete Induktivität verlust arm auszubilden, ist die Dämpfung des Schwingkreises i.a. sehr gering; seine typische Güte Q liegt bei etwa Q=200. Somit bleibt die Resonanzschwingung des Schwingkreises lange genug erhalten, um im frei schwingenden Zustand messen zu können. Die Schwingung kann bis zu mehreren Minuten bestehen bleiben.

Die so erreichte Störungsfreiheit erlaubt es, auch winzige tatsächlich auftretende Abweichungen von der rein sinusförmigen Schwingung dem Einfluß der Isolation des Prüfobjekts zuzuschreiben und zwar genauer dem nichtlinearen elektrischen Verhalten der Isolation. (Die Induktivität kann bei entsprechender Auslegung im Nicht-Sättigungsbereich ihrer ggf. vorhandenen Eisenkerne betrieben werden, so daß sie sich praktisch linear verhält). Damit kann man auch vor Ort Messungen kleinster Signale und nichtsinusförmiger (genauer: die Sinusform verändernde) Beiträge, die Information über das Isolationsmaterial tragen (wie etwa Teilentladungssignale) und herkömmlicherweise von externen Störungen völlig verschüttet sind, durchführen. Wegen der so erreichten hohen Sensitivität kann man bei dem erfindungsgemäßen Verfahren in der Regel das Anlegen von Überspannungen an das Prüfobjekt vermeiden, es genügt meist die Betriebsspannung des Prüfobjekts oder sogar eine kleinere Spannung. Das Abkoppeln bzw. Ausschalten im Schritt b) kann also vor, bei oder kurz nach Erreichen der Betriebsspannung erfolgen. Falls gewünscht, kann das Verfahren aber auch im Überspannungsbereich durchgeführt werden.

Als Prüfobjekte kommen für das erfindungsgemäße Verfahren alle Arten von kapazitiv wirkenden Objekten in Betracht, z.B. Kabel oder Kabelsysteme einschließlich deren Systemkomponenten wie Verbindungsmuffen, Kabelendverschlüsse und andere Garnituren, daneben aber auch reine Dielektrika, die nur für die Messung in das Feld eines Kondensators gebracht werden.

Beispielsweise ist ein als Prüfobjekt dienendes Mittelspannungs- oder Hochspannungskabel ein Kondensator, und zwar ein langestreckter Koaxialkondensator: Die leitende Seele des Kabels bildet die eine Kondensatorelektrode, eine äußere halbleitende Schicht des Kabels bildet die andere. Die dazwischenliegende Kabelisolierung bildet ein Dieelek trikum zwischen den Kondensatorelektroden.

Insbesondere bei einer Vor-Ort-Prüfung wird der für das Verfahren benötigte Schwingkreis nicht von vornherein vorhanden sein, sondern muß erst durch Zusammenschaltung des zu prüfenden Kabels oder Kabelsystems mit der Induktivität aufgebaut werden. Das Verfahren kann aber auch von einem bereits bestehenden Schwingkreis ausgehen, beispielsweise wenn im Labor die Alterung eines bestimmten Prüfobjekts laufend erforscht werden soll.

Um das freie Schwingen des Schwingkreises herbeizuführen, wird die Energieeinspeisevorrichtung abgekoppelt und/oder ausgeschaltet. Ein Beispiel für eine Abkoppeln ist das Abtrennen eines der Energieeinspeisung dienenden Frequenzumrichters vom Schwingkreis, etwa mit Hilfe eines oder mehrerer in der Energiespeiseleitung angeordneter Reed-Relais. Ein Beispiel für ein Abschalten ist das Öffnen der für die Frequenzumrichtung verantwortlichen elektronischen Schalter des Frequenzumrichters (der Schwingkreis selbst wird hierbei nicht etwa unterbrochen). Bei einem thyristorgestuerten Umrichter wird das Abschalten einfach dadurch erzielt, daß die Thyristoren nicht mehr gezündet werden. In der Wirkung entspricht dies einem "Abtrennen".

Um zur Erfindung zu gelangen, wurde zunächst erkannt, daß bei herkömmlichen Resonanz-Spannungsüberhöhungsmessungen im Betriebsfrequenzbereich i.a. große externe Störsignale vorliegen, die kleine, der Schwingkreisschwingung überlagerte schwingkreisintrinsische Signale oder Größen verschütten. Weiter wurde erkannt, daß das Messen gerade dieser verschütteten Signale oder Größen besonders aussagekräftig sein kann und materialschädigende Spannungsprüfungen überflüssig machen kann. Es wurde schließlich gefunden, daß man durch Abtrennen bzw. Ausschalten der Energieeinspeisevorrichtung externe Störsignale einfach und wirksam weitgehend ausschalten kann und verbleibende kleinste Abweichungen von der Sinusform der Schwingkreisschwingung im wesentlichen auf den Einfluß der Isolation des Prüfobjekts zurückgehen. In diesem Zusammenhang wurde auch erkannt, daß die Dämpfung des Schwingkreises i.a. so klein ist, daß die frei schwingende Schwingung lange genug anhält, um diese Abweichungen messen zu können.

Das erfindungsgemäße Verfahren hat also folgende Vorteile:
- es ermöglicht mit relativ einfachen, vor Ort verfügbaren Mitteln bei Wechselspannungsbeaufschlagung des Prüfobjekts die Messung kleinster Signale und Größen, die mit Isolationseigenschaften des Prüfobjekts in Verbindung stehen;
- es erlaubt dadurch eine frühzeitigere Aufdeckung von Isolationsfehlern, insbesondere auch bei Vor-Ort-Messungen; und
- es kann im Betriebsspannungsbereich oder sogar darunter durchgeführt werden und ist damit völlig zerstörungsfrei.

Es sei noch angemerkt, daß bei der eingangs erwähnten DE 37 00 647 A1 der durch Kabel und Induktivität gebildete Schwingkreis zeitweise von der äußeren Spannungsquelle abgekoppelt wird. Dies dient aber nur dazu, mit Hilfe einer äußeren Spannungsquelle mit nur einer Polarität Prüfspannungen mit zwei verschiedenen Polaritäten erzeugen zu können. Der Schwingkreis wird nämlich nur zum Umpolen der Polarität des Kabels jeweils nur für eine halbe Schwingungsperiode benötigt. Der Umpolungsvorgang selbst spielt für die Messung keine Rolle, da es bei dieser Anlage nur darum geht, etwaige Durchschläge festzustellen, die während der Beaufschlagung mit der (quasi stationären) positiven oder negativen Prüfspannung auftreten können. Dies geht in eine andere Richtung als die Erfindung.

Das erfindungsgemäße Verfahren wird aufgrund seiner hervorragenden Störungsfreiheit bei gleichzeitig geringem Anlagenaufwand bevorzugt vor Ort durchgeführt (Anspruch 2). Die Eignung zur Vor-Ort-Prüfung ist ein besonders vorteilhafter Aspekt, da nur so bereits installierte Kabel und Kabelsysteme mit vertretbarem Aufwand geprüft werden können.

Bevorzugt erfolgt die Speisung des Schwingkreises mit einer Wechselgröße, insbesondere einer im wesentlichen sinusförmigen Wechselgröße. Grundsätzlich kann die Speiseenergie in der Frequenz von der Resonanzfrequenz des Schwingkreises abweichen oder auch breitbandig sein. Grundsätzlich möglich ist auch die Speisung mit einer Gleichspannung, mit welcher der Kondensator vor dem Freischwingen ggf. wiederholt aufgeladen wird. Um jedoch die Speiseenergie effektiv in den Schwingkreis einkoppeln zu können, wird jedoch vorteilhaft zum Energieeinspeisen eine Energieeinspeisefrequenz im wesentlichen gleich der Resonanzfrequenz des Schwingkreises gewählt. Grundsätzlich kann man dies durch Anpassen der Resonanzfrequenz an die gegebene Energieeinspeisefrequenz tun, etwa durch Verändern der Induktivität. Bevorzugt paßt man jedoch die Energieeinspeisefrequenz der gegebenen Resonanzfrequenz an, z.B. mit Hilfe eines frequenzverstellbaren Frequenzumformers oder -umrichters. Besonders bevorzugt entnimmt man die Energie aus einem Netz und formt sie auf eine Wechselgröße mit Resonanzfrequenz um (Anspruch 3).

In beiden Fällen muß man die Resonanzfrequenz entweder von vornherein kennen oder zunächst ermitteln, beispielsweise durch Messen elektrischer Größen im Schwingkreis (z.B. Strom oder Spannung) bei gleichzeitigem Ändern der Energieeinspeisefrequenz, bis die elektrische Größe einen Extremwert, z.B. einen Maximalwert erreicht hat.

Grundsätzlich kann die Speiseenergie direkt einem Stromerzeuger, z.B. einem fahrbaren kraftgetriebenen Generatoraggregat entnommen werden. Die besonders bevorzugte Entnahme der Energie aus einem Netz, üblicherweise einem 50 oder 60 Hz-Netz, hat jedoch den Vorteil, daß kein entsprechender Stromerzeuger oder ähnliches für die Prüfung vor Ort mitgeführt werden muß.

Um das Prüfobjekt möglichst unter realen Bedingungen zu testen, wird die Resonanzfrequenz vorteilhaft im Bereich der Frequenz gewählt, mit der das Prüfobjekt im üblichen Betrieb einem Wechselfeld ausgesetzt wird (Anspruch 4). Insbesondere liegt die Testfrequenz in einem Bereich einer tolerablen Abweichung von +/- 30 Hz von der Betriebsfrequenz (i.a. 50 oder 60 Hz).

Bevorzugt wird die Resonanzfrequenz des Schwingkreises fortlaufend überwacht und die Energieeinspeisefrequenz auf die Resonanzfrequenz geregelt (Anspruch 5). Dadurch kann sichergestellt werden, daß Änderungen der Resonanzfrequenz während des Verfahrens ausgeglichen werden können und somit das Energieeinspeisen immer optimal, d.h. bei Resonanzfre quenz, erfolgt.

Besonders vorteilhaft wird die Abfolge der Verfahrensschritte a), b) und c) wiederholt durchgeführt (Anspruch 6), z.B. mehr als 10 bis 1000 mal. Dadurch kann man einer seits bei zufallsverteilten Vorgängen, wie z.B. Teilentla dungen, den statistischen Meßfehler verringern, und andererseits bei nichtzufallsverteilten, z.B. periodischen Vorgängen durch phasenrichtiges Addieren der einzelnen Messungen das Signal-Rausch-Verhältnis verbessern.

Bevorzugt wird das Energieeinspeisen geregelt durchgeführt und zwar durch Durchführen des Schrittes a) bis eine am Prüfobjekt abfallende Spannung ein Anfangsniveau für die Prüfung, z.B. die Betriebsspannung, erreicht und Durchfüh ren des Schrittes b) für jeweils eine einstellbare Zeit bzw. Anzahl von Perioden (Anspruch 7). Auf diese Weise können einerseits vergleichbare Anfangsbedingungen für nacheinander durchzuführende Messungen geschaffen werden. Andererseits erleichtert ein geregeltes Einspeisen bzw. Abkoppeln und oder Ausschalten der Energieeinspeisevorrichtung ein phasengleiches Einspeisen ermöglicht werden.

Bevorzugt kann wenigstens eine weitere Induktivität in den Schwingkreis und/oder wenigstens eine weitere Energieeinspeisevorrichtung hinzugefügt werden (Anspruch 8). Dies ermöglicht einerseits ein Anpassen der Resonanzfrequenz des Schwingkreises über einen größeren Bereich. Für größere Leistungen kann man mehrere Energieeinspeisevorrichtungen parallel schalten.

Grundsätzlich kann man bei dem erfindungsgemäßen Verfahren im Schritt c) die verschiedensten Arten von Messungen durchführen. Besonders vorteilhaft sind zwei im folgenden genannte Meßarten.

Vorteilhaft können nämlich mit dem Verfahren im Schritt c) Teilentladungen gemessen werden (Anspruch 9). Solche Teilentladungen überbrücken - anders als Durchschläge - nicht die gesamte Potentialdifferenz im Prüfkörper, sondern nur einen kleinen Teil hiervon. Sie treten hauptsächlich in den gasgefüllten Hohlräumen der Isolation bzw. des Dielektrikums auf. Diese Hohlräume können entweder im Isolationsmaterial selbst oder als Spalten zwischen zwei verschiedenen Isolierkomponenten vorkommen. Ferner können Teilentladungen an Übergängen zwischen verschiedenen Systemkomponenten, wie Kabeln und Garnituren (Verbindungsmuffen, Kabelendverschlüsse u.ä.) auftreten, beispielsweise wenn an deren Trennflächen Verschmutzungen oder Lufträume eingeschlossen sind. Auch können verschiedene Alterungsprozesse und Materialveränderungen im Material zu Teilentladungen führen. Teilentladungen erodieren auf Dauer die Isolation und lassen so wachsende Kanäle entstehen, die in einem sich verstärkenden Prozeß zum (Voll-)Durchschlag führen.

Zur Messung von Teilentladungen wird hohe Wechselspannung (z.B. Betriebsspannung nahe der Betriebsfrequenz) an das Isoliersystem des Kabels oder Kabelsystems angelegt. Die Teilentladungen zeigen sich nach außen in Form sehr kleiner Spannungsimpulse, die der am Prüfobjekt abfallenden Wechselspannung überlagert sind. Das Verhältnis dieser Impulse zur angelegten Spannung beträgt typischerweise 1/10⁷. Herkömmlicherweise machen äußere Störungen das Erfassen dieser kleinen Signale vor Ort praktisch unmöglich. Mit dem erfindungsgemäßen Verfahren ist dies jedoch aufgrund dessen weitgehender Störungsfreiheit möglich. Die Teilentladungs signale sind sehr steil ansteigend, können also z.B. mit Hilfe eines Hochpasses von der niederfrequenten Hochspannungswelle abgetrennt werden.

Eine andere vorteilhafte Messung besteht darin, im Verfah rensschritt c) eine elektrische Größe, welche Informationen über Isolationseigenschaften des Prüfobjekts trägt, fourierzutransformieren (Anspruch 10). Auf diese Weise erhält man ein Fourierspektrum dieser Größe, welches dem Erkennen von materialspezifischen Eigenschaften und von Materialänderungen dient. Man kann so eine Isolationsdiagnostik und insbesondere eine Früherkennung einer "Water-Tree"-Bildung (unter "Water-Tree" versteht man eine baumförmige Strukturveränderung im Isoliermaterial aufgrund eindiffundierten Wassers) und andere materialinnere Alterungsprozesse durchführen.

Hierzu folgende Erläuterung: Unter Einwirkung eines elektrischen Wechselfeldes kommt es in einem idealen Kondensator (d.h. einem Kondensator ohne Dielektrikum und ohne Verluste) zu einem rein kapazitiven (d.h. um 90° zur Spannung phasenverschobenen) Verschiebungsstrom. Die Anwesenheit eines ideal isolierenden Dielektrikums im Kondensator bedingt einen zusätzlichen Polarisationsstrom, der neben einer kapazitiven Komponente eine nicht-phasenverschobene Komponente hat. Dazu kommt - da ein reales Dielektrikum nicht vollständig isoliert - ein Leitungsstrom, der nichtphasenverschoben ist. Kapazitive Stromkomponenten führen zu reiner Blindleistung, während nicht-phasenverschobene zu einer Wirkleistung führen und daher auch als "Verluststrom" bezeichnet werden. Das Verhältnis von nicht-phasenverschobener zu kapazitiver Gesamt-Komponente liegt bei guten Isolationen bei etwa 1/10⁴.

Die Verlustströme sind i.a. komplizierte nichtlineare Funktionen der angelegten Spannung; das Ohmsche Gesetz gilt für sie also nicht. Als Folge hat der Verluststrom bei sinusförmiger angelegter Spannung einen nicht-sinusförmigen Verlauf. Seine genaue Form ist von Material zu Material verschieden. Diese Phänomen haben A. Gemant im Aufsatz "Oszillographie von Strömen in Isolierstoffen" im Archiv für Elektrotechnik, XXIII. Band, 1930, und Fritz Liebscher im Aufsatz "Über die dielektrischen Verluste und die Kurvenform der Ströme in geschichteten Isolierstoffen bei hohen Wechselfeldsträrken von 50 Hz", 1942 beschrieben. Praktische Bedeutung hat dies allerdings nicht gewonnen. Durch die hier vorgeschlagene Fouriertransformation der Zeitfunktionen erhält man aussagekräftige Resultate, mit denen man mit hoher Genauigkeit auf das vorliegende Dielektrikum, seinen Alterungszustand und weitere Materialveränderungen, wie sog. water-trees schließen kann. Die Störungsfreiheit des erfindungsgemäßen Verfahrens wirkt sich in diesem Zusammenhang sehr vorteilhaft aus.

Es ist aus der US-Patentschrift 5 047 724 bekannt, das Auftreten von Durchschlägen in Niederspannungs-Gleichstromkreisen mit Hilfe von Fouriertransformation zu detektieren. Man nutzt hier aus, daß bei Auftreten eines Durchschlags hochfrequente Rauschsignale im Gleichspannungskreis auftreten, die auf der Zufallsfluktuationscharakteristik von Lichtbögen beruhen. Eine gezielte Beaufschlagung eines Prüfobjekts mit einer (insb. sinusförmigen) Wechselgröße - wie bei der Erfindung - um einem zu prüfenden Isolationsmaterial ohne Durchschlag Information über seinen Zustand zu "entlocken", findet hier aber nicht statt. Ein Zusammenhang mit der oben dargestellten Ausgestaltung der Erfindung ist daher nicht gegeben.

Ferner ist es aus der US-Patentschrift 4 799 005 bekannt, die in Hochspannungs-Freileitungen fließenden Ströme und die in ihnen auftretenden Spannungen relativ zur Erde zu messen und fourierzutransformieren. Dies dient dazu, Information über den Oberwellenanteil von Versorungsströmen und -spannungen zu messen, die beispielsweise durch Rückwirkung von mit elektronischen Schaltern gesteuerten Verbrauchern entstehen können. Ein Zusammenhang mit der obigen Ausgestaltung der Erfindung ist nicht gegeben.

Vorzugsweise wird bei der Messung gemäß der obigen Ausgestaltung der Erfindung als die elektrische Größe der durch das Prüfobjekt fließende Verluststrom (I_{pw}+I_{R}), der Gesamtstrom (I_{c}), der kapazitive Strom (I_{Co}+I_{pc}) oder einer dieser Ströme ohne den Grundwellenanteil verwendet (Anspruch 11). Wie oben ausgeführt, trägt vor allem der Verluststrom die Information über die Nichtlinearitäten des Materials des Prüfobjekts. Er wird daher in erster Linie der Messung zugrundegelegt. Da er aber auch einen Teil des Gesamtstroms bildet, kann grundsätzlich auch dieser zur Messung verwendet werden. Nicht ausgeschlossen ist ferner, daß auch die kapazitive Komponente des Polarisationsstromes I_{pc} Nichtlinearitäten enthält und so der gesamte kapazitive Strom (I_{Co}+I_{pc}) zur Messung verwendet werden kann.

Um eine Verfälschung von Meßergebnissen durch die zur Messung verwendete Meßeinrichtung auszuschließen, wird vorzugsweise die Übertragungsfunktion der Meßeinrichtung bestimmt. Falls eine Fouriertransformation durchgeführt wird, wird der Einfluß der Übertragungsfunktion der Meßeinrichtung auf das Ergebnis der Fouriertransformation eliminiert, so daß sich ein sog. resultierendes Fourierspektrum ergibt (Anspruch 12). Bei verschiedenen Einstellungen der Meßeinrichtung, z.B. einer Meßbrücke, die bei jeder Messung auf eine unterschiedliche Grundfrequenz abzugleichen ist, wird die Übertragungsfunktion der Meßeinrichtung für jede Einstellung bestimmt, z.B. mittels eines Signalgenerators. Anhand der Übertragungsfunktion kann beispielsweise mit Hilfe eines Computers jeweils das ursprüngliche, von der Meßeinrichtung unabhängige Signal zurückgerechnet werden. Somit können verschiedene Messungen verglichen werden, unabhängig davon, mit welcher Meßeinrichtung und welcher Einstellung sie ermittelt wurden.

Vorzugsweise wird das aus der Fouriertransformation entstandene Fourierspektrum bzw. das resultierende Fourierspektrum analysiert und/oder das Spektrum mit einem früher (mit demselben Prüfobjekt) gewonnenen Spektrum oder einem (auf das Material des Prüfobjekts bezogenen) Referenzspektrum verglichen (Anspruch 13). Auf diese Weise können Rückschlüsse auf materialspezifische Eigenschaften des Prüfobjekts gezogen werden, beispielsweise kann gefolgert werden, um welches Material es sich handelt oder wie alt ein bestimmtes Material ist bzw. wieviel Betriebsstunden es bereits im Einsatz war. Ferner können Eigenschaften wie water-tree-Bildung, thermisch bedingte chemisch-physikalische Prozesse usw. erkannt werden. Allgemein können somit Alterungsprozesse und sonstige Veränderungen im Material diagnostiziert werden.

Erfindungsgemäß wird ferner eine Vorrichtung zum Bestimmen von Isolationseigenschaften von Prüfobjekten, insbesondere eines Kabels oder Kabelsystems, unter Wechselgrößenbeaufschlagung, insbesondere im Mittel- oder Hochspannungsbereich, bereitgestellt, mit wenigstens einer Induktivität, mit der ein das Prüfobjekt als Kapazität oder Teil einer Kapazität umfassender Schwingkreis gebildet werden kann, wenigstens einer Energieeinspeisevorrichtung zum Energieeinspeisen in den Schwingkreis, wenigstens einem Mittel zum Abkoppeln und/oder Ausschalten der Energieeinspeisevorrichtung, so daß der Schwingkreis mit einer im wesentlichen sinusförmigen Schwingung auf der Resonanzfrequenz frei schwingen kann, und einer Meßeinrichtung zum Messen von Beiträgen zur Schwingung, welche Abweichungen von der Sinusform bedingen und Information über Isolationseigenschaften tragen, während abgekoppelter bzw. ausgeschalteter Energieeinspeisevorrichtung (Anspruch 14). Diese Vorrichtung ist insbesondere zur Durchführung des erfindungsgemäßen Verfahrens oder einer dessen o.g. Weiterbildungen vorgesehen.

Für einen Einsatz vor Ort ist die Vorrichtung vorzugsweise transportabel, insbesondere fahrbar, ausgebildet (Anspruch 15), beispielsweise ist sie auf einem Lastkraftwagen aufgebaut.

Bevorzugt ist wenigstens eine Energieeinspeisevorrichtung frequenzeinstellbar ausgebildet, um die Energieeinspeisefrequenz an die Resonanzfrequenz anpassen und bevorzugt die Einspeiseenergie aus einem Netz entnehmen zu können (Anspruch 16). Auf diese Weise kann besonders einfach die Energieeinspeisefrequenz gleich der Resonanzfrequenz gewählt werden, um die oben beschriebene Resonanzüberhöhung von Strom und Spannung zu erreichen. Ferner kann die frequenzeinstellbare Energieeinspeisevorrichtung zum Auffinden der Resonanzfrequenz dienen. Indem beispielsweise die Frequenz von niedrigen zu hohen Frequenzen durchfahren wird, kann durch Messen elektrischer Größen (z.B. Strom, Spannung) im Schwingkreis ermittelt werden, wo die Resonanzfrequenz liegt.

Vorzugsweise weist die Vorrichtung eine Steuer- bzw. Regeleinrichtung auf, die - insbesondere optoelektronisch - mit der Meßeinrichtung und/oder wenigstens einer Energieeinspeisevorrichtung gekoppelt ist, um insbesondere die Resonanzfrequenz des Schwingkreises überwachen und die Energieeinspeisefrequenz auf die Resonanzfrequenz regeln zu können (Anspruch 18). Die Steuer- bzw. Regeleinrichtung kann auch das Energieeinspeisen insgesamt und auch das Messen von Meßgrößen gesteuert bzw. geregelt durchführen. Durch die optoelektronische Kopplung der Meßeinrichtung mit der Steuer- bzw. Regeleinrichtung und/oder die optoelektronische Kopplung von Steuer- bzw. Regeleinrichtung mit der Energieeinspeisevorrichtung erzielt man eine galvanische Trennung zwischen diesen Ein- bzw. Vorrichtungen. Dies trägt dazu bei, die Störeinflüsse auf die empfindliche Meßeinrichtung und daneben auf die Steuer- bzw. Regeleinrichtung minimal zu halten.

Vorzugsweise ist die Vorrichtung mit Mitteln zum gesteuerten bzw. geregelten wiederholten Energieabkoppeln und/oder -ausschalten und ggf. auch mit Mitteln zum gesteuerten bzw. geregelten wiederholten Energieeinspeisen versehen (Anspruch 19). Dem Einkoppeln von Energie können beispielsweise ein oder mehrere Transformatoren dienen, die mit einer Wicklung in den Schwingkreis geschaltet sind und mit der anderen mit der Energieeinspeisevorrichtung, z.B. einem Frequenzumrichter o.ä. gekoppelt sind. Die Mittel zum Energieabkoppeln können z.B. zwischen den Frequenzumrichter und die andere Transformatorwicklung geschaltete elektronische oder mechanische Schalter (z.B. Reed-Relais) sein. Die Mittel zum Ausschalten der Energieeinspeisevorrichtung - und auch zum wiederholten Energieeinspeisen können z.B. Teil einer Ansteuerelektronik des Frequenzumrichters sein, die ein beliebiges des Aus- und Einschalten des Ausgangs des Frequenzumrichters erlauben.

Bevorzugt weist die Vorrichtung Mittel zum Fouriertransformatieren elektrischer Größen auf (Anspruch 22). Diese dienen vorzugsweise dazu, die Resonanzschwingung mit den Beiträgen (oder die Beiträge allein) fourierzutransformieren. Dies kann z.B. ein festverdrahteter Fourieranalysator, ein entsprechend ausgestatteter und programmierter Computer oder Mischformen hiervon, ggf. jeweils mit vorgeschaltetem Signal-Analysator sein. Die Mittel sind insbesondere für eine schnelle Fourieranalyse eingerichtet (sog. FFT).

Bevorzugt ist die Vorrichtung mit Mitteln zum Bestimmen der Übertragungsfunktion der Meßeinrichtung ausgerüstet und - falls Mittel zur Fouriertransformation vorgesehen sind - mit Mitteln zum Eliminieren des Einflusses der Übertragungsfunktion der Meßeinrichtung auf das Ergebnis der Fouriertransformation, um ein resultierendes Fourierspektrum zu erhalten (Anspruch 23). Dies können Mittel, wie ein Computer sein, die einerseits die Fourieranalyse durchführen und anderereseits z.B. einen Signalgenerator ansteuern, der wiederum die Meßeinrichtung mit einem Signal bestimmter Amplitude und ggf. Phase und einer bestimmten (durchzufahrenden) Frequenz betreibt.

Besonders bevorzugt weist die Vorrichtung Mittel zum Analysieren des Fourierspektrums der elektrischen Größe bzw. des jeweiligen resultierenden Fourierspektrums und/oder Vergleichen des jeweiligen Fourierspektrums mit einem früher gewonnenen oder einem entsprechenden Referenzspektrum auf (Anspruch 24). Um schnell zu Ergebnissen zu gelangen, zählen hierzu wiederum insbesondere Computer, die die Spektren analysieren bzw. vergleichen können und aus diesem Grund auf Daten früherer Messungen bzw. Referenzdaten zurückgreifen können.

Bezüglich weiterer Eigenschaften und Vorteile der Gegenstände der Vorrichtungsansprüche, insbesondere der hier nicht abgehandelten, wird auf die obigen Erläuterungen der Verfahrensansprüche verwiesen.

Die Maßnahmen des Anspruchs 10 bzw. 22 können allgemein bei jeder Art von Wechselgrößenbeaufschlagung - auch anderen als der nach Anspruch 1 bzw. 14 angegebenen - vorteilhaft sein. Es wird daher der Vorbehalt erklärt, die Gegenstände des Anspruchs 10 bzw. 22 und der darauf rückbezogenen Unteransprüche auch ohne Rückbezug auf einen der Ansprüche 1 bis 9 bzw. 14 bis 21 zu beanspruchen.

Nachfolgend wird die Erfindung anhand bevorzugter Ausführungsbeispiele unter Bezug auf die beigefügte Zeichnung näher beschrieben.

In der Zeichnung zeigen:
- Fig. 1: ein schematisches Schaltbild einer Vorrichtung zum Durchführen des Verfahrens;
- Fig. 2: ein schematisches Ablaufdiagramm des Verfahrens;
- Fig. 3: ein schematisches Diagramm eines zeitlichen Verlaufs der Spannung im Schwingkreis;
- Fig. 4: ein Zeigerdiagramm mit durch das Prüfobjekt fließenden Strömen und anliegender Spannung;
- Fig. 5: ein schematisches Diagramm eines zeitlichen Verlaufs des Verluststromes;
- Fig. 6: ein Diagramm eines Verluststrom-Frequenzspektrums eines neuen Kabels;
- Fig. 7: ein Diagramm eines Verluststrom-Frequenzspektrums eines Kabels mit Water-Tree-Bildung;
- Fig. 8: ein schematisches Schaltbild einer Meßvorrichtung zur Verluststromanalyse mit einer Scheringbrücke;
- Fig. 9: ein schematisches Schaltbild einer Meßvorrichtung zur Verluststromanalyse mit einer Stromkomperator-Meßbrücke;
- Fig. 10: ein Schaltbild einer Meßvorrichtung zur Verluststromanalyse und zum Messen der Übertragungsfunktion einer Meßeinrichtung und
- Fig. 11: ein idealisiertes Ersatzschaltbild eines Kabels bzw. eines Kabelsystems zur Veranschaulichung der Entstehung von Teilentladungssignalen.

In der Figur sind im wesentlichen funktionsgleiche Teile oder Größen mit gleichen Bezugszeichen versehen.

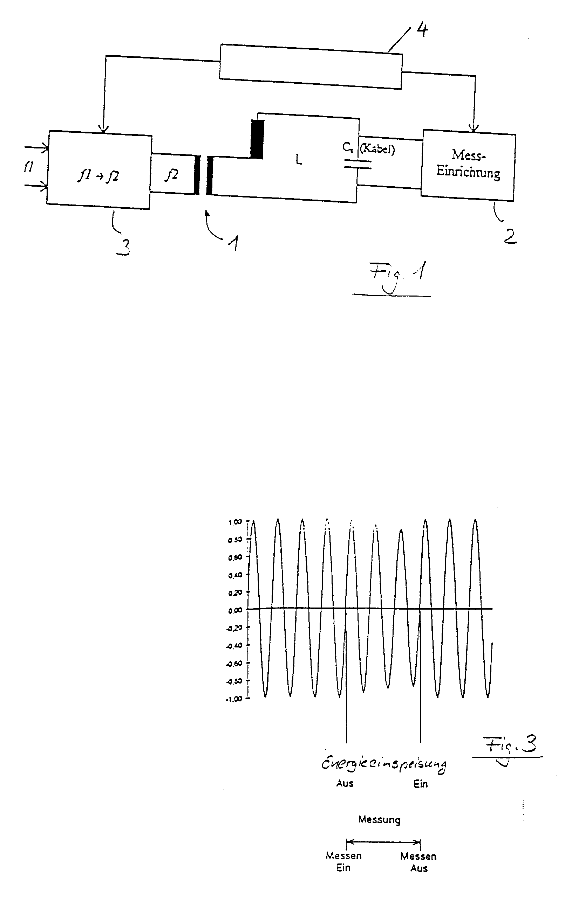

Nachfolgend werden Ausführungsformen der Vorrichtung und des Verfahrens beschrieben. Fig. 1 zeigt eine zu untersuchende Kapazität Cₓ, die das Prüfobjekt darstellt bzw. ein Teil eines Prüfobjekts sein kann. Es kann sich dabei - wie oben ausgeführt wurde - um ein oder mehrere Kabel oder ein Kabelsystem handeln, aber auch um ein Dielektrikum, das in eine Kapazität eingebracht wird und dessen Isolationseigenschaften untersucht werden sollen. Im weiteren wird angenommen, daß es sich bei Cₓ um die Kapazität eines Kabels oder Kabelsystems handelt.

Eine Induktivität L und die Sekundärwicklung eines Transformators 1 sind mit der Kapazität Cₓ in Reihe geschaltet. Diese Elemente bilden so einen Schwingkreis. Der Transfor mator 1 dient zum Einspeisen von Energie in den Schwingkreis. Außerdem ist eine Meßeinrichtung 2 vorgesehen, um elektrische Größen an der Kapazität Cₓ zu messen.

Eine Energieeinspeisevorrichtung 3 ist eingangsseitig mit einem Netz mit Frequenz f1 mit beispielsweise 50 oder 60 Hz koppelbar und ist ausgangsseitig mit der Primärwicklung des Transformators 1 verbunden. Die Energieeinspeisevorrichtung 3 umfaßt einen Frequenzumformer oder -umrichter (hier einen thyristorgesteuerten Frequenzumrichter), der die eingangsseitige Frequenz f1 in eine einstellbare ausgangsseitige Frequenz f2 umwandeln kann. Bei anderen (nicht gezeigten) Ausführungsformen umfaßt die Energieeinspeisevorrichtung einen (z.B. von einem Verbrennungsmotor angetriebenen) Generator, der direkt die Frequenz f2 liefern kann.

Eine Steuer- bzw. Regeleinrichtung 4 steuert die Energieeinspeisevorrichtung 3 sowie Mittel zum Ausschalten der Energieeinspeisevorrichtung 3. Im einfachsten Fall liegen diese Mittel in der Ausschaltbarkeit der Energiespeisevorrichtung 3, sind also in dieser integriert. Bei anderen (nicht gezeigten) Ausführungsformen sind alternativ oder ergänzend Mittel zum Abkoppeln der Energieeinspeisevorrichtung vom Schwingkreis vorhanden, die ebenfalls von der Steuer- bzw. Regelvorrichtung gesteuert werden. Diese Mittel zum Abkoppeln können beispielsweise elektronische oder mechanische Schalter (z.B. Reed-Relais) sein, die jeweils zwischen die Energieeinspeisevorrichtung und die Primärwicklung des Transformators geschaltet sind, um erstere vollständig vom Schwingkreis abtrennen zu können. Auch die Meßeinrichtung 2 ist mit der Steuer- bzw. Regeleinrichtung gekoppelt, um dieser einerseits Signale zu Steuerungszwec ken zu liefern und andererseits selbst gesteuert werden zu können.

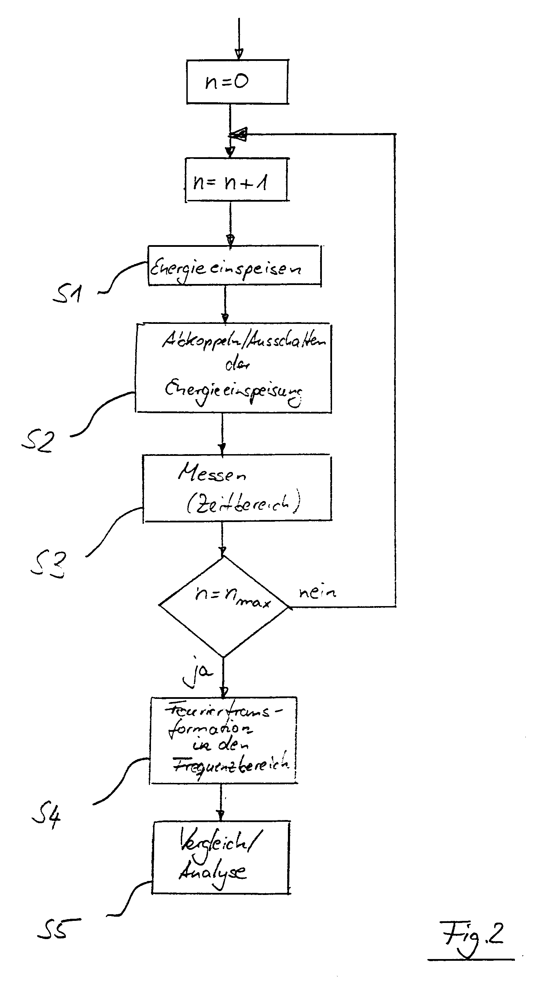

In den Schwingkreis wird nun nach Auffinden der Resonanzfrequenz elektrische Energie mit einer Frequenz eingespeist, die im wesentlichen dieser Resonanzfrequenz entspricht, und zwar mittels der Energieeinspeisevorrichtung 3 über den Transformator 1 (Fig. 2, Schritt S1). Bei Erreichen der sog. Anfangsspannung, d.h. einer vorgegebenen Maximalspannung am Prüfobjekt wird die Energiespeisevorrichtung 3 ausgeschaltet (z.B. indem die Thyristoren des Frequenzumrichters nicht mehr gezündet werden) und ggf. alternativ oder zusätzlich vom Transformator 1 getrennt, so daß der Schwingkreis mit seiner Resonanzfrequenz frei weiter schwingt (Schritt S2). Er hat somit keine Verbindung mehr mit dem Netz und ggf. auch nicht mit der (ausgeschalteten) Energieeinspeisevorrichtung, so daß keine Störungen mehr von dort in den Schwingkreis gelangen können. Bereits in den Schwingkreis gelangte Störsignale erfüllen nicht die Resonanzbedingung und sterben unmittelbar aus, so daß sich eine im wesentlichen rein harmonische Schwingung ausbildet. Die Abnahme der Schwingungsamplitude ist so klein, daß Messungen über eine ausreichende Zahl von Schwingungsperioden (z.B. 1-300) hinweg bei sich kaum verändernder Spannung durchgeführt werden können (Schritt S3).

Die Ausschaltung der Energieeinspeisevorrichtung und/oder ggf. deren Abtrennung von der Steuer- bzw. Regeleinrichtung 4 erfolgt vorzugsweise für eine oder mehrere Schwingungsperioden, besonders vorzugsweise für eine einstellbare vorbestimmte Zeit oder Anzahl von Schwingungsperioden, z.B. 1-300 Schwingungsperioden. Nach Ablauf dieser Zeit bzw. Erreichen dieser Anzahl schaltet die Steuer- bzw. Regeleinrichtung 4 die Energieeinspeisung 3 wieder ein bzw. koppelt sie wieder an, so daß die Spannung wieder auf das Anfangsniveau zurückgeregelt wird. Die Steuer- bzw. Regeleinrichtung 4 schaltet während der Energieeinspeisepause die Messung ein. Um weitere mögliche Störungen zu vermeiden, ist die Steuer- bzw. Regeleinrichtung 4 optoelektronisch mit der Meßeinrichtung 2 und/oder mit der Energieeinspeisevorrichtung 3 gekoppelt.

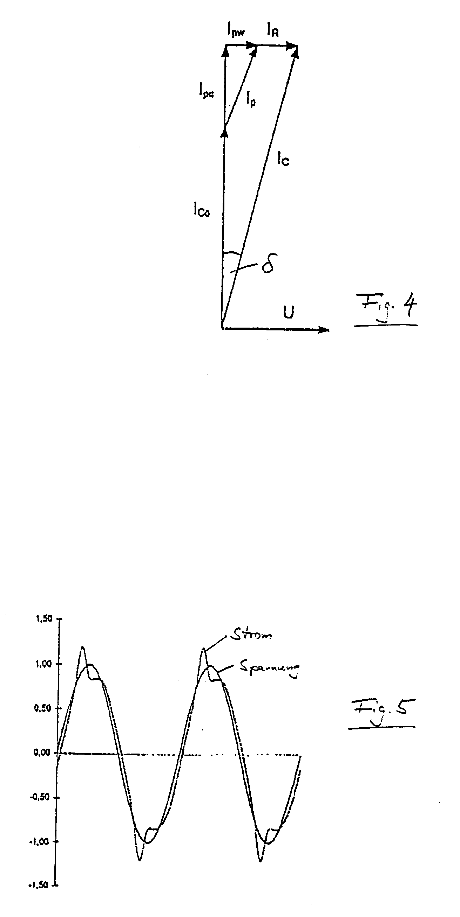

Fig. 3 zeigt einen Ausschnitt des zeitlichen Verlaufs der bei dem Verfahren am Prüfobjekt anliegenden Spannung. Der Spannungsanstieg auf das Anfangsniveau erfolgt hier in kurzer Zeit nach dem Einschalten der Energiespeisevorrich tung 3, so daß er als Sprung erscheint. Man sieht, wie während einer Einspeisepause bei leicht absinkender Spannung die Messung durchgeführt werden kann. Dieser Vorgang wird periodisch z.B. n-mal wiederholt, wie auch Fig. 2 zeigt. Nach n Wiederholungen werden bei den Einzelmessungen gewonnene Ergebnisse zusammengefaßt und - wie im folgenden detailliert beschrieben wird - fouriertransformiert (Schritt S4). Das Ergebnis der Fouriertransformation wird dann analysiert und/oder z.B. mit Referenzergebnissen verglichen (Schritt S5).

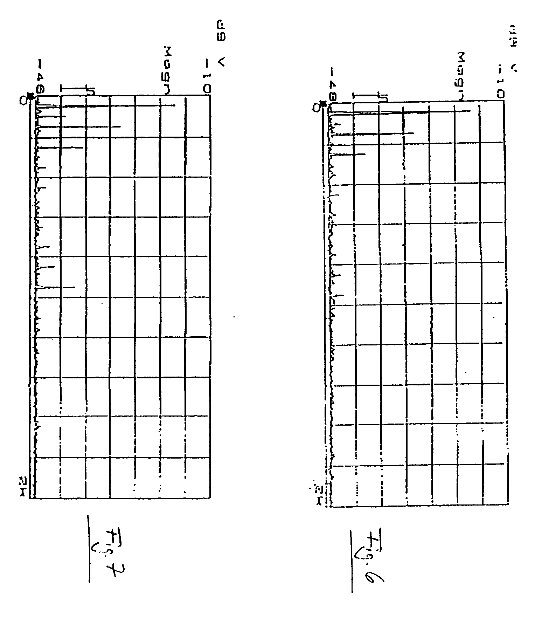

Fig. 4 zeigt ein Zeigerdiagramm mit der am Prüfobjekt (Kapazität Cₓ) anliegenden Spannung U sowie dem durch das Prüfobjekt fließenden Gesamtstrom I_{C}. Zur Veranschaulichung ist gezeigt, wie sich dieser Gesamtstrom aus Komponenten verschiedener physikalischer Herkunft zusammensetzt: Ein dem Verschiebungsstrom in dem (gedachten) idealen Prüfobjektkondensator ohne Dielektrikum entsprechender kapazitiver Strom I_{Co} eilt um 90° der Spannung vor. Ein von dem als ideal isolierend angenommenes Dielektrikum herrührender Polarisationsstrom Iₚ eilt um weniger als 90° vor. Ein Leitungsstrom I_{R} rührt schließlich von dem das reale Dielektrikum durchtretenten Strom aufgrund dessen nicht völlig verschwindenden Leitfähigkeit her, er liegt in Phase mit der Spannung U und trägt so zu einer Wirkleistung bei.

Der Polarisationsstrom Iₚ läßt sich zerlegen in eine Komponente I_{pw}, die ebenfalls in Phase liegt mit der Spannung U und somit auch zu einer Wirkleistung beiträgt; sie bildet zusammen mit dem Leitungsstrom I_{R} den sog. Verluststrom. Die andere Komponente I_{pc} des Polarisationsstrom Iₚ ist kapazitiv, eilt also der Spannung U um 90° vor. Es ergeben sich somit im Zeigerdiagramm einerseits ein Verluststrom I_{pw} + I_{R} und andererseits ein kapazitiver Gesamtstrom I_{Co} + I_{pc}.

Aufgrund eines i.a. nichtlinearen Strom-Spannungs-Zusammenhangs des Isolationsmaterials sind diese Ströme nicht - wie die anliegende Spannung U - rein harmonisch, sondern sind mit Oberwellen behaftet. Das heißt, der Betrag des Zeigers I_{R} und auch der Betrag und Winkel des Zeigers Iₚ, und damit auch I_{C}, sind nicht konstant, sondern abhängig von der augenblicklichen Phasenlage. Das Zeigerdiagramm gemäß Fig. 4 kann so nur die Verhältnisse bei der Grundfrequenz-Komponente veranschaulichen.

Der Tangens des in Fig. 4 angegebenen Verlustwinkels δ bedeutet das Verhältnis vom Verluststrom I_{pw} + I_{R} zum kapazitiven Gesamtstrom I_{Co}+ I_{pc}. Dieser Verlustfaktor tanδ liegt bei hochwertigen Hochspannungskabeln typischerweise im Bereich 1/1000 bis 1/10000.

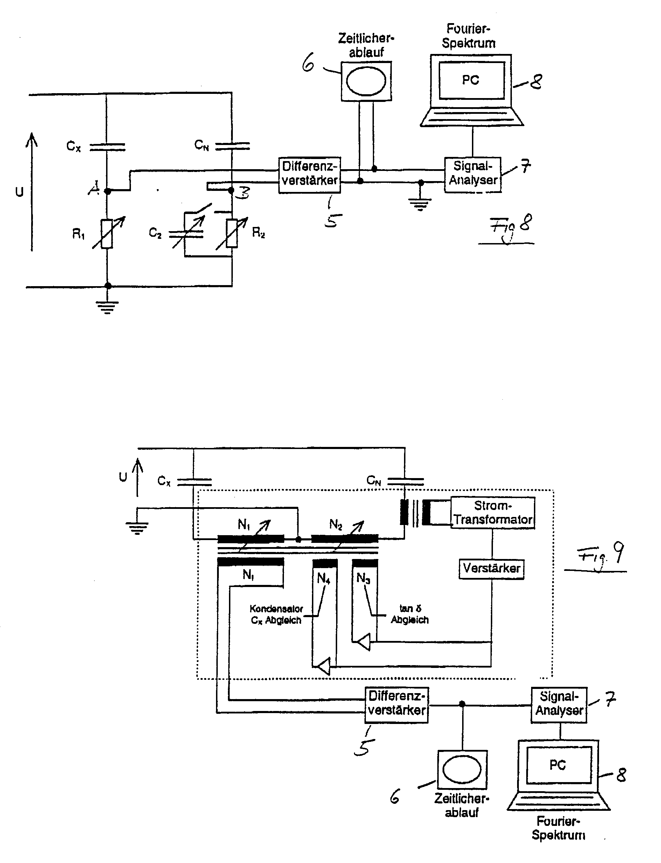

Fig. 5 zeigt als rein harmonische Schwingung die Spannung U und als oberwellenbehaftete Schwingung den Verluststrom I_{pw} + I_{R}.

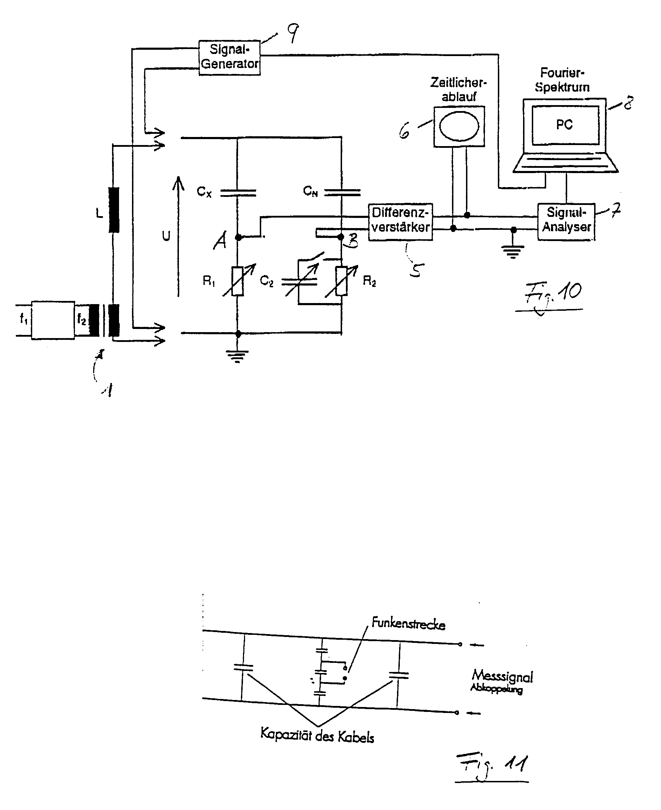

Die spektrale Verteilung des Verluststromes (d.h. die verteilung der Beiträge zur Resonanzschwingung, die diese nichtsinusförmig machen, als Funktion der Frequenz, ggf. mit oder ohne Grundwellenanteil) enthält hochspezifische Informationen über Materialeigenschaften des Isolierstoffes. Das Fourierspektrum des Verluststromes ist gewissermaßen ein "Fingerabdruck" des Isolierstoffes. Man kann mit ihm verschiedene Isolierstoffe unterscheiden. Da zudem Alterungsprozesse, Water-Tree-Bildung und andere Änderungsprozesse die Spektralverteilung eines Isolierstoffes verändern, kann man durch Fourieranalyse des Verluststroms Aufschluß über den Fortschritt solcher Prozesse und damit über den Zustand des Kabels gewinnen. Beispielsweise zeigt Fig. 6 das Verluststromspektrum eines neuen Kabels und Fig. 7 das Verluststromspektrum eines Kabel mit Water-Tree-Bildung. Man erkennt, daß bestimmte Oberwellenanteile in Fig. 7 erheblich stärker ausgeprägt sind als in Fig. 6. Diese charakteristischen Unterschiede erlauben eine hochspezifische Bewertung des Kabelzustands, wobei bestimmte Isolationsschäden bereits lange vor dem Auftreten eines Durchschlags auffindbar sind.

Grundsätzlich kann es sein, daß eine solche Information nicht nur in der Spektralverteilung des Verluststromes, sondern auch der des kapazitiven Stromes enthalten ist, und zwar herrührend aus dem kapazitiven Polarisationsstrom I_{pc}. Aus Gründen der Meßtechnik ist es jedoch schwieriger, den extrem dominierenden Grundwellenanteil des kapazitiven Stromes I_{Co} + I_{pc} von den Oberwellenanteilen zu trennen. Meßtechnisch ist es wesentlich einfacher, vom Gesamtstrom I_{C} den Verluststrom I_{pw} + I_{R} (mit seiner nicht dominierenden Grundwelle) abzutrennen und zu analysieren.

Das Abtrennen des Gesamt-Verluststromes I_{pw} + I_{R} vom Gesamtstrom I_{C} kann insbesondere mit Brückenschaltungen erfolgen.

Fig. 8 zeigt eine Meßvorrichtung zur Verluststromanalyse mit einer solchen Brückenschaltung, die sog. Scheringbrücke. Durch geeigneten Abgleich kann mit ihrer Hilfe der Verluststrom I_{pw} + I_{R} vom Gesamtstrom I_{C} abgetrennt werden. Cₓ die zu untersuchende Kapazität bzw. das Prüfobjekt in Form eines Kabels bzw. Kabelsystems, C_{N} bezeichnet eine ideale Kapazität, R₁ und R₂ bezeichnen jeweils einen verstellbaren Widerstand und C₂ bezeichnet eine abschaltbare und verstellbare ideale Kapazität.

Zwischen den Brückenpunkten A und B ist ein Differenzverstärker 5 geschaltet, um einerseits die kleinen Signale zu verstärken, und um andererseits den Einfluß beiden Brückenpunkten gemeinsamer Spannungspegel, die bezüglich nachgeschalteter (ggf. geerdeter) Geräte vorliegen könnten, auszuschalten. Der zeitliche Verlauf der zwischen den Punkten A und B abgegriffenen Spannung läßt sich dann mit einem geeigneten Gerät betrachten, beispielsweise einem Oszilloskop 6.

Ferner wird das Signal am Ausgang des Differenzverstärkers 5 einem Signal-Analysator 7 zugeführt. Anschließend gelangt das vom Signal-Analysator 7 aufgearbeitete Signal zu einem Computer 8, der die Fouriertransformation ausführt und das Fourierspektrum zur Darstellung bringt.

Die Brückenschaltung kann auf zweierlei Weisen betrieben werden:

Erstens kann sie im abgeglichenen Zustand (d.h. im Zustand der Spannungsgleichheit von A und B bei der Grundfrequenz) betrieben werden. Die Grundwelle wird dann nicht erfaßt bzw. würde auf einem Oszilloskop nicht dargestellt werden.

Zweitens kann sie bei nicht vollständig abgeglichener Brückenschaltung bzw. bei zunächst abgeglichener Brückenschaltung und anschließend verstelltem R betrieben werden. Dann erscheint auf dem Oszilloskop 6 bzw. einem Null-Indikator ein mit dem Verluststrom proportionales Spannungssignal. Kapazitive Ströme bleiben abgeglichen und werden nicht angezeigt.

Die Brückenschaltung kann außerdem zur Messung der Kapazität Cₓ und des Verlustfaktors tanδ verwendet werden.

Fig. 9 zeigt eine andere Art von Meßbrücke für die Verluststromanalyse, nämlich eine Stromkomperatormeßbrücke. Wiederum bezeichnet Cₓ die verlustbehaftete Kapazität des Prüfobjekts, C_{N} bezeichnet eine ideale Kapazität. Bei dieser Schaltung wird der Abgleich der Brücke mittels veränderlicher Transformatorübersetzungen erreicht. N₁, N₂, N₃, N₄ bezeichnen jeweils die Windungszahlen von Transformatorwicklungen, aus denen sich die Übersetzungsverhältnisse der Transformatoren ergeben. Auch diese Schaltung ist mit einem Differenzverstärker 5, einem Oszilloskop 6, einem Signal-Analysator 7 und einem Computer 8 versehen. Analog zur Meßvorrichtung mit Schering-Brücke kann hiermit der Verluststrom I_{pw} + I_{R} abgetrennt und analysiert werden.

Fig. 10 zeigt eine Meßvorrichtung entsprechend Fig. 8, die jedoch zusätzlich eine Schaltung zur Messung der Übertragungsfunktion der Meßbrücke aufweist. Diese Messung der Übertragungsfunktion erfolgt, indem allein die Meßbrücken schaltung betrachtet wird, d.h. ohne zugeschaltete Induktivität L sowie ohne zugeschaltete Energieeinspeisung, also ohne Energieeinspeisevorrichtung 3 und Transformator 1. Sie läuft folgendermaßen ab: Zunächst wird das Prüfobjekt in die Meßbrücke geschaltet, sodann wird die Meßbrücke mit einem definierten Eingangssignal einer bestimmten Frequenz beaufschlagt, und das Ausgangssignal, also das Signal zwischen den Punkten A und B bzw. am Ausgang des Differenzverstärkers wird gemessen, im Signal-Analysator 7 und im Computer 8 weiterverarbeitet und schließlich mit dem Eingangssignal verglichen. Durch Durchfahren aller (praktisch vorkommenden) Frequenzen läßt sich hieraus die Übertragungsfunktion der Meßbrücke ermitteln. In entsprechender Weise läßt sich hieraus übrigens nicht nur die Übertragungsfunktion einer Meßbrücke, sondern auch jeder anderen Meßeinrichtung bestimmen.

Eine Brückenschaltung kann i.a. immer nur für eine Frequenz abgeglichen werden kann. Von Abgleicheinstellung zu Abgleicheinstellung erscheinen andere Frequenzen (Oberwellen) verschiedenartig gedämpft. Um die Meßergebnisse von verschiedenen Abgleicheinstellungen miteinander vergleichen zu können, sollte daher der Einfluß dieser verschiedenen Dämpfungen eliminiert werden. Dazu wird die zuvor bestimmte Übertragungsfunktion der Meßeinrichtung für jede Abgleicheinstellung benötigt. Dies kann insbesondere erfolgen, indem nach jeder Messung die Übertragungsfunktion der Brücke bei der jeweiligen Abgleicheinstellung mittels eines Signal-Generators 9 gemessen wird. Anschließend wird anhand dieser Übertragungsfunktion mit Hilfe eines Computers 8 das ursprüngliche, schaltungsunabhängige Signal zurückgerechnet.

Eine andere wichtige Messung zur Diagnostik von Prüfobjekten, insbesondere Hochspannungs-Kabeln und -Systemen ist die Messung von Teilentladungen. Man führt sie vorzugsweise im Zeitbereich durch, benötigt also i.a. keine Einrichtungen zur Fouriertransformation. Die Messung läuft wiederum so ab, daß zunächst Energie in den Schwingkreis eingespeist wird (Schritt S1), dann die Energieeinspeisung bei einer bestimmten Spannung abgekoppelt bzw. ausgeschaltet wird (Schritt S2) und anschließend beispielsweise die über dem Prüfobjekt abfallende Spannung gemessen (Schritt S3) bzw. mittels eines Oszilloskops 6 analysiert wird. Teilentladungen führen ebenfalls zu Abweichungen von der Sinusfrom der Schwingkreisschwingung: Sie zeigen sich in einer Überlagerung der Eigenschwingung des Schwingkreises mit einzelnen zufallsverteilten Signalen ("Peaks"), die eine hohe Flankensteilheit aufweisen (entsprechend Frequenzen im Bereich von 20-200 kHz und höher). Diese Teilentladungssignale können daher einfach vom Gesamtsignal abgetrennt werden, beispielsweise mit Hilfe eines Hochpasses oder Bandpasses.

Das resultierende Signal kann dann weiter untersucht werden. Beispielsweise kann die Anzahl der Teilentladungspeaks sowie deren Amplitude genauen Aufschluß über den Isoliermaterial-Zustand bzgl. Teilentladungen geben. Auch die Phasenlage der Teilentladungspeaks relativ zur Grundwelle kann Information tragen, und zwar über den Ort der Teilentladung im Inneren des Prüfobjekts. So zeigen sich sog. Koronaentladungen nicht-feststoffisolierter Elektroden, z.B. Zuführungen vornehmlich bei den Maximalwerten der anliegenden Spannung, während Teilentladungsvorgänge im Inneren des Isolationsmaterials jedoch vorwiegend im Bereich der Null-Durchgänge der anliegenden Spannung auftreten.

Zur Verdeutlichung der elektrischen Verhältnisse bei Teilentladungen sei auf Fig. 11 verwiesen. Sie zeigt ein Ersatzschaltbild eines Kabels bzw. eines Kabelsystems. Dieses läßt sich als Parallel-Reihen-Schaltung von vielen Kapazitäten vorstellen. Hohlräume lassen sich durch mit den Kapazitäten parallelgeschalteten Funkenstrecken symbolisieren, die durch die Teilentladungen kurzgeschlossen werden, was sich außen an den Kabelklemmen jeweils in einem oben beschriebenen Teilentladungspeak bemerkbar macht. Bei feststoffisolierten Kabeln oder Kabelsystemen können Teilentladungen hauptsächlich in gasgefüllten Hohlräumen der Isolation auftreten, die entweder in einem durchgehenden Isolierkörper oder an Grenzflächen zwischen zwei Isolierkörpern vorkommen, wie an zusammengesetzten Isolationen und Garnituren (etwa Endverschlüssen und Verbindungsmuffen).

Mit dem erfindungsgemäßen Verfahren und der dazugehörigen Vorrichtung läßt sich der überwiegende Teil der auftretenden Störungen einfach und wirksam ausschalten. Nicht vollständig unterdrücken lassen sich nur atmosphärische Störungen (z.B. Rundfunksignale). Solche Störungen sind im allgemeinen relativ klein und können zudem näherungsweise durch Vergleichsmessungen, z.B. mit Hilfe einer Antenne ermittelt und dann vom Signal eliminiert werden. Daneben besteht die Möglichkeit, sie auf der Basis ihrer vom Nutzsignal abweichenden Frequenzcharakteristik von den Nutzsignalem abzutrennen, sei es mit Hilfe von entsprechenden Bandpässen, sei es mit Hilfe von Frequenzschnitten im Fourierspektrum.

### Bezugszeichenliste

- 1: Transformator
- 2: Meßeinrichtung
- 3: Energieeinspeisevorrichtung
- 4: Steuer- bzw. Regeleinrichtung
- 5: Differenzverstärker
- 6: Oszilloskop
- 7: Signal-Analysator
- 8: Computer
- 9: Signalgenerator
- δ: Verlustwinkel
- Cₓ: Kapazität des Prüfobjekts
- L: Induktivität

## Patentansprüche

1. Verfahren zum Bestimmen von Isolationseigenschaften von Prüfobjekten, insbesondere eines Kabels oder Kabelsystems, unter Wechselgrößenbeaufschlagung, insbesondere im Mittelspannungs- oder Hochspannungsbereich, unter Verwendung einer Schaltung, die das Prüfobjekt als Kapazität oder Teil einer Kapazität sowie eine Induktivität umfaßt und einen Schwingkreis bildet, mit folgenden Schritten:
a) Energieeinspeisen in den Schwingkreis mit Hilfe einer Energieeinspeisevorrichtung,
b) Abkoppeln und/oder Ausschalten der Energieeinspeisevorrichtung, so daß der Schwingkreis mit einer im wesentlichen sinusförmigen Schwingung auf der Resonanzfrequenz frei schwingt,
c) Messen von Beiträgen zur Schwingung, welche Abweichungen von der Sinusform bedingen und Information über Isolationseigenschaften tragen, während abgekoppelter bzw. ausgeschalteter Energieeinspeisevorrichtung.

2. Verfahren nach Anspruch 1, welches vor Ort durchgeführt wird.

3. Verfahren nach Anspruch 1 oder 2, bei welchem zum Energieeinspeisen eine Energieeinspeisefrequenz im wesentlichen gleich der Resonanzfrequenz des Schwing kreises gewählt wird, bevorzugt durch Anpassen der Energieeinspeisefrequenz und besonders bevorzugt durch Entnehmen der - zum Einspeisen in den Schwingkreis notwendigen - Energie aus einem Netz und Umformen dieser Energie auf eine Wechselgröße mit Resonanzfrequenz.

4. Verfahren nach einem der vorstehenden Ansprüche, bei welchem die Resonanzfrequenz im Bereich der Frequenz gewählt wird, mit der das Prüfobjekt im üblichen Betrieb einem Wechselfeld ausgesetzt wird.

5. Verfahren nach einem der vorstehenden Ansprüche, bei welchem die Resonanzfrequenz des Schwingkreises fortlaufend überwacht und die Energieeinspeisefrequenz auf die Resonanzfrequenz geregelt wird.

6. Verfahren nach einem der vorstehenden Ansprüche, bei welchem die Abfolge der Verfahrensschritte a), b) und c) wiederholt durchgeführt wird.

7. Verfahren nach Anspruch 6, bei welchem das Energieeinspeisen geregelt durchgeführt wird und zwar durch Durchführen des Schrittes a) bis eine am Prüfobjekt abfallende Spannung ein Anfangsniveau erreicht und Durchführen des Schrittes b) für jeweils eine einstellbare Zeit bzw. Anzahl von Perioden.

8. Verfahren nach einem der vorstehenden Ansprüche, bei welchem wenigstens eine weitere Induktivität in den Schwingkreis und/oder wenigstens eine weitere Energieeinspeisevorrichtung hinzugefügt wird.

9. Verfahren nach einem der vorstehenden Ansprüche, bei welchem im Schritt c) Teilentladungen gemessen werden.

10. Verfahren nach einem der vorstehenden Ansprüche, bei welchem im Schritt c) eine elektrische Größe, welche Informationen über Isolationseigenschaften des Prüfobjekts trägt, fouriertransformiert wird.

11. Verfahren nach Anspruch 10, bei welchem als die elektrische Größe ein durch das Prüfobjekt fließender Verluststrom (I_{pw}+I_{R}), ein Gesamtstrom (I_{C}), ein kapazitiver Strom (I_{Co}+I_{pc}) oder einer dieser Ströme ohne den Grundwellenanteil verwendet wird.

12. Verfahren nach einem der vorstehenden Ansprüche 10, bei welchem die Übertragungsfunktion einer Meßeinrichtung bestimmt wird und - falls eine Fouriertransformation durchgeführt wird - der Einfluß der Übertragungsfunktion der Meßeinrichtung auf das Ergebnis der Fouriertransformation eliminert wird, so daß sich ein resultierendes Fourierspektrum ergibt.

13. Verfahren nach einem der Ansprüche 11 bis 13, bei welchem das aus der Fouriertransformation entstandenen Fourierspektrums bzw. das resultierende Fourierspektrums analysiert und/oder das Spektrum mit einem früher gewonnenen Spektrum oder einem Referenzspektrum verglichen wird.

14. Vorrichtung, insbesondere zum Durchführen eines Verfahrens nach einem der Ansprüche 1 bis 13, zum Bestimmen von Isolationseigenschaften von Prüfobjekten, insbesondere eines Kabels oder Kabelsystems, unter Wechselgrößenbeaufschlagung, insbesondere im Mittelspannungs- oder Hochspannungsbereich, mit
- wenigstens einer Induktivität (L), mit der ein das Prüfobjekt als Kapazität (Cₓ) oder Teil einer Kapazität umfassender Schwingkreis gebildet werden kann,
- wenigstens einer Energieeinspeisevorrichtung (3) zum Energieeinspeisen in den Schwingkreis,
- wenigstens einem Mittel zum Abkoppeln und/oder Ausschalten der Energieeinspeisevorrichtung (3), so daß der Schwingkreis mit einer im wesentlichen sinusförmigen Schwingung auf der Resonanzfrequenz frei schwingen kann, und
- einer Meßeinrichtung (2) zum Messen von Beiträgen zur Schwingung, welche Abweichungen von der Sinusfrom bedingen und Information über Isolationseigenschaften tragen, während abgekoppelter bzw. ausgeschalteter Energieeinspeisevorrichtung (3).

15. Vorrichtung nach Anspruch 14, welche transportabel, insbesondere fahrbar, ist.

16. Vorrichtung nach Anspruch 14 oder 15, bei welcher wenigstens eine Energieeinspeisevorrichtung (3) frequenzeinstellbar ausgebildet ist, um die Energieeinspeisefrequenz an die Resonanzfrequenz anpassen zu können und insbesondere Einspeiseenergie aus einem Netz entnehmen zu können.

17. Vorrichtung nach einem der Ansprüche 14 bis 16, bei welcher die Resonanzfrequenz des Schwingkreises im Bereich der Frequenz liegt, mit der das Prüfobjekt üblicherweise im Wechselfeld betrieben wird.

18. Vorrichtung nach einem der Ansprüche 14 bis 17 mit einer Steuer- bzw. Regeleinrichtung (4), die - insbesondere optoelektronisch - mit der Meßeinrichtung (2) und/oder wenigstens einer Energiespeisevorrichtung (3) gekoppelt ist, um insbesondere die Resonanzfrequenz des Schwingkreises überwachen und die Energieeinspeisefrequenz auf die Resonanzfrequenz regeln zu können.

19. Vorrichtung nach einem der Ansprüche 14 bis 18 mit
- Mitteln zum gesteuerten bzw. geregelten wiederholten Energieabkoppeln und/oder -ausschalten und ggf.
- Mitteln zum gesteuerten bzw. geregelten wiederholten Energieeinspeisen.

20. Vorrichtung nach einem der Ansprüche 14 bis 19 mit Mitteln zum Erfassen von Teilentladungen aus gemessenen elektrischen Größen.

21. Vorrichtung nach einem der Ansprüche 14 bis 20 mit Mitteln zum Erhalten einer elektrischen Größe, welche Informationen über die Isolationseigenschaften des Prüfobjekts trägt, insbesondere ein durch das Prüfobjekt fließender Gesamtstrom (I_{C}), ein Verluststrom (I_{pw}+I_{R}), ein kapazitiver Strom (I_{Co}+I_{pc}) oder einer dieser Ströme ohne den Grundwellenanteil.

22. Vorrichtung nach Anspruch 21 mit Mitteln (8) zum Fouriertransformieren der elektrischen Größe.

23. Vorrichtung nach einem der Ansprüche 14 bis 22 mit Mitteln zum Bestimmen der Übertragungsfunktion der Meßeinrichtung (2) und - falls Mittel (8) zur Fouriertransformation vorgesehen sind - mit Mitteln zum Eliminieren des Einflusses der Übertragungsfunktion der Meßeinrichtung (2) auf das Ergebnis der Fouriertransformation, um ein resultierendes Fourierspektrum zu erhalten.

24. Vorrichtung nach Anspruch 22 oder 23 mit Mitteln (8) zum Analysieren des Fourierspektrums der elektrischen Größe bzw. des jeweiligen resultierenden Fourierspektrums und/oder Vergleichen des jeweiligen Fourierspektrums mit einem früher gewonnenen oder einem entsprechenden Referenzspektrum.
